# EUROPÄISCHE PATENTSCHRIFT

(11) **EP 2 974 570 B1**
(45) Veröffentlichungstag und Bekanntmachung des Hinweises auf die Patenterteilung: **16.05.2018**
(21) Anmeldenummer: 14705034.8
(22) Anmeldetag: 14.02.2014
(51) Int. Cl.: H05K 5/02

(54) **ELEKTROGERÄT MIT GEHÄUSE UND AUF DEM GEHÄUSE AUFSETZBAREM DECKEL**
ELECTRICAL DEVICE HAVING A HOUSING AND A COVER THAT CAN BE PLACED ON THE HOUSING
APPAREIL ÉLECTRIQUE POURVU D'UN CORPS ET D'UN COUVERCLE POUVANT ÊTRE POSÉ SUR LE CORPS

(30) Priorität: 12.03.2013 DE 102013004189
(43) Veröffentlichungstag der Anmeldung: 20.01.2016
(73) Patentinhaber: Sew-Eurodrive GmbH & Co. KG, 76646 Bruchsal (DE)
(72) Erfinder: SCHÖRNER, Martin, 76646 Bruchsal (DE); SCHMIDT, Josef, 76676 Graben-Neudorf (DE); HUBER, Martin, 77830 Bühlertal (DE)
(86) Internationale Anmeldenummer: PCT/EP2014/000403
(87) Internationale Veröffentlichungsnummer: WO 2014/139626

(56) Entgegenhaltungen:
- EP-A1- 2 023 466
- WO-A1-2006/016464
- WO-A1-2006/056512
- DE-U1- 29 606 194
- JP-A- 2001 201 640
- JP-U- H0 666 081

## Beschreibung

Die Erfindung betrifft ein Elektrogerät mit Gehäuse und auf dem Gehäuse aufsetzbarem Deckel.

Es ist allgemein bekannt, dass Kabel durch Kabelverschraubungen führbar sind, wobei die Kabelverschraubungen in bearbeitete Oberflächenabschnitte eines Gussgehäuses einzusetzen sind, um Dichtheit herstellbar zu machen.

**Aus der** JP H06 66081 U **ist ein Elektrogerät mit Gehäuse und auf dem Gehäuse aufgesetztem Deckel bekannt, wobei in einer Vertiefung des Gehäuses ein Dichtungselement angeordnet ist, das zwischen dem Gehäuse und dem Deckel angeordnet ist.**

Der Erfindung liegt daher die Aufgabe zugrunde, ein Elektrogerät mit Gehäuse weiterzubilden, wobei eine möglichst kostengünstige und einfache Herstellung ermöglicht wird.

Erfindungsgemäß wird die Aufgabe bei dem Elektrogerät mit Gehäuse nach den in Anspruch 1 angegebenen Merkmalen gelöst
Wichtige Merkmale der Erfindung bei dem Elektrogerät mit Gehäuse und auf dem Gehäuse aufsetzbarem Deckel sind, dass in einer Vertiefung des Gehäuses, insbesondere der Wandung des Gehäuses, ein Dichtungselement angeordnet ist, das zwischen dem Gehäuse und dem Deckel angeordnet ist,
wobei das Dichtungselement eine Ausnehmung zur Durchführung eines Kabels aufweist,
wobei das Kabel in einer geschwungen verlaufenden Nut des Gehäuses, insbesondere der Wandung des Gehäuses, eingelegt ist,
wobei das Gehäuse einen Krallenabschnitt aufweist, der in die Schirmung des Kabels eingekrallt und/oder eingeschnitten ist.

Von Vorteil ist dabei, dass schon durch bloßes Einlegen des Kabels in die Nut die elektrische Verbindung zum Gehäuse herstellbar ist und somit auch eine sehr gute Erdung erreichbar ist.

Außerdem ist das Gehäuse als Gussgehäuse herstellbar, wobei zur Herstellung der Dichtheit keine Bearbeitung derjenigen Oberflächenabschnitte des Gehäuses ausgeführt werden muss, an welchen das Dichtungselement das Gehäuse berührt. Denn das Dichtungselement ist aus derart elastischem Material ausgeführt, dass sich das Material des Dichtungselements unter dem von dem Deckel auf das Dichtungselement ausgeübtem Druck an die Oberflächenabschnitte anschmiegt und dadurch abdichtet, also eine hohe Schutzart erreichbar ist..

Bei einer vorteilhaften Ausgestaltung ist das Gehäuse samt Krallenabschnitt aus Metall, insbesondere Aluminium, ausgebildet. Von Vorteil ist dabei, dass die Schneidfähigkeit sehr effektiv ist, also mit scharfkantigen Krallenabschnitten ohne großen Kraftaufwand ein genügend tiefes Einschneiden erreichbar ist..

Bei einer vorteilhaften Ausgestaltung ist zwischen Deckel und Gehäuse eine Dichtung, insbesondere Flachdichtung angeordnet ist, insbesondere die am Deckel angespritzt ist,
insbesondere wobei beim Aufsetzen des Deckels die Dichtung abschnittsweise gegen das Gehäuse und in einem anderen Abschnitt gegen das Dichtungselement gepresst ist, insbesondere so dass das Dichtungselement in die Vertiefung gedrückt ist. Von Vorteil ist dabei, dass eine hohe Schutzart erreichbar ist. Außerdem wird das Dichtungselement von dem Deckel in die Vertiefung hineingedrückt und somit eine hohe Dichtheit herstellbar.

Bei einer vorteilhaften Ausgestaltung weist das Dichtungselement, insbesondere ein Schenkelabschnitt des Dichtungselements, eine Ausnehmung auf, durch welche das Kabel hindurchgeführt ist,
wobei eine Dichtlippe, insbesondere umlaufende Dichtlippe, des Dichtungselements am Kabel anliegt. Von Vorteil ist dabei, dass eine hohe Schutzart erreichbar ist. Außerdem ist eine einfache Herstellung ausführbar. Insbesondere bei Ausführung des Dichtungselements aus einem Elastomer ist eine hohe Schutzart, insbesondere IP54 oder höher, erreichbar durch das Anschmiegen des Materials des Dichtungselements an das Gehäuse.

Mittels des auf das Gehäuse aufgesetzten Deckels wird das Dichtungselement zwischen dem Deckel und dem Gehäuse gequetscht und dabei das durch die Ausnehmung des Dichtungselements geführte Kabel noch dichter verbunden.

Bei einer vorteilhaften Ausgestaltung verläuft die geschwungen verlaufende Nut S-förmig verläuft. Von Vorteil ist dabei, dass eine Zugentlastung erreichbar ist. Dabei wird das Kabel bei Zugbelastung in der Nut verklemmt und die Krallenabschnitte schneiden sich in die Schirmung des Kabels ein, so dass eine elektrische Kontaktierung erreichbar ist. Der auf das Gehäuse aufgesetzte Deckel begrenzt somit zusammen mit der geschwungen verlaufenden Nut das Kabel, welches somit in der Nut verbleiben muss.

Bei einer vorteilhaften Ausgestaltung ist im Gehäuse quer zur Kabelrichtung eine Nut ausgeformt,
insbesondere wobei quer zur Nutrichtung und quer zur Kabelrichtung eine Seitennut im Gehäuse ausgeformt ist,
wobei das Dichtungselement in die Nut und/oder Seitennut hineinragt und somit in Kabelrichtung und entgegen der Kabelrichtung begrenzt ist und/oder im Gehäuse gehalten ist. Von Vorteil ist dabei, dass das Dichtungselement sicher gehalten ist im Gehäuse. Die quer zur Kabelrichtung verlaufende Nut, also Quernut, und die Seitennut fixieren das Dichtungselement im Gehäuse.

Bei einer vorteilhaften Ausgestaltung weist das Dichtungselement, insbesondere ein weiterer Schenkelabschnitt des Dichtungselements, eine weitere Ausnehmung auf, durch welche ein weiteres Kabel hindurchgeführt ist,
wobei eine Dichtlippe, insbesondere umlaufende Dichtlippe, des Dichtungselements am weiteren Kabel anliegt,
insbesondere wobei das Kabel in einer geschwungen verlaufenden Nut des Gehäuses, insbesondere der Wandung des Gehäuses, eingelegt ist,
insbesondere wobei das Gehäuse einen Krallenabschnitt aufweist, der in die Schirmung des Kabels eingekrallt und/oder eingeschnitten ist,
insbesondere wobei das Dichtungselement einen Jochabschnitt aufweist, der die Schenkelabschnitte miteinander verbindet. Von Vorteil ist dabei, dass mehrere Kabel zuführbar, in hoher Schutzart verbindbar und bei jeweiliger Zugbelastung des Kabels dieses in der jeweils geschwungen verlaufenden Nut des Gehäuses verklemmbar sowie mit einem jeweiligen Krallenabschnitt kontaktierbar ist.

Bei einer vorteilhaften Ausgestaltung weist das Kabel eine Leitung auf, die von einem Isoliermaterial umgeben ist, welches von einer Schirmung umgeben ist,
insbesondere wobei im Bereich der Dichtlippe des Dichtungselements ein Mantel aus elektrisch isolierendem Material die Schirmung umgibt,
insbesondere wobei das Kabel im Bereich der Krallenabschnitte entmantelt ist. Von Vorteil ist dabei, dass eine einfache Herstellung des Kabels und einfach herstellbare elektrische Kontaktierung erreichbar ist.

Bei einer vorteilhaften Ausgestaltung ist er lichte Innendurchmesser der Nut im Bereich des Krallenabschnitts kleiner als der Außendurchmesser des entmantelten Kabels. Von Vorteil ist dabei, dass ein elektrisches Verbinden durch Einschneiden des Krallenabschnitts in die Schirmung in einfacher Weise erreichbar ist.

Bei einer vorteilhaften Ausgestaltung ist das Elektrogerät mit Gehäuse vorgesehen,
wobei ein Lüftermodul in einer Vertiefung des Gehäuses aufgenommen und mit dem Gehäuse rastverbunden ist,
wobei das Lüftermodul ein Trägerteil aufweist, mit dem ein Lüfter rastverbunden ist,
wobei eine mit elektronischen Bauelementen bestückte Leiterplatte vom Trägerteil aufgenommen ist, insbesondere in einem durch einen umlaufenden Wandabschnitt des Trägerteils gebildeten Vertiefungsbereich oder Aufnahmebereich,
wobei eine Dichtungskappe mit dem Trägerteil verbunden ist, insbesondere auf den umlaufenden Wandabschnitt übergestülpt aufgesteckt ist,
wobei die bestückte Leiterplatte im von der Dichtungskappe, insbesondere von der aus Gummi oder einem anderen Elastomer hergestellten Dichtungskappe, und vom Trägerteil, insbesondere vom als Kunststoffspritzgussteil hergestellten Trägerteil, umgebenen Raumbereich angeordnet ist.

Von Vorteil ist dabei, dass das Lüftermodul rastverbunden ist mit dem metallischen Gehäuse. Somit ist eine einfache Austauschbarkeit des Lüftermoduls gewährleistet beziehungswiese eine einfache Trennbarkeit bei Entsorgung des Elektrogeräts. Die den Lüfter ansteuernde und/oder speisende Elektronische Schaltung ist geschützt zwischen Dichtungskappe und Trägerteil anordenbar. Auch der Lüfter ist einfach verbindbar oder trennbar.

Bei einer vorteilhaften Ausgestaltung weist die Dichtungskappe einen Ringkragenabschnitt auf, der an einem am Gehäuse ausgeformten Rohrabschnitt anliegt, wobei der Rohrabschnitt eine durch das Gehäuse, insbesondere durch die Wandung des Gehäuses, durchgehende Ausnehmung umgibt. Von Vorteil ist dabei, dass eine Versorgungsleitung von der Leiterplatte zum Innenraum des Gehäuses durch eine durchgehende Ausnehmung führbar ist, wobei die Durchführung abgedichtet ausgeführt ist.

Bei einer vorteilhaften Ausgestaltung sind am Trägerteil Zentrierstiftabschnitte ausgeformt, mit denen der Lüfter positioniert ist,
wobei am Trägerteil eine Rastnase ausgeformt ist, mittels derer der Lüfter mit dem Trägerteil rastverbunden ist,
wobei am Trägerteil Ausnehmungen angeordnet sind, durch welche der vom Lüfter angesaugte Luftstrom hindurchführbar ist,
wobei der Lüfter auf der dem Gehäuse zugewandten Seite des Trägerteils angeordnet ist. Von Vorteil ist dabei, dass das Trägerteil samt der Rastnasen, und zentrierabschnitte sowie den um die Leiterplatte umlaufenden Wandabschnitt einstückig ausformbar ist. Somit ist eine einfache Herstellung bewirkbar und eine einfache Trennbarkeit der Materialien bei Entsorgung des Elektrogeräts.

Bei einer vorteilhaften Ausgestaltung ist die Leiterplatte mit einer den Lüfter speisenden elektronischen Schaltung bestückt, deren Versorgungsleitung durch eine vom Ringkragenabschnitt umgebene Ausnehmung hindurchgeführt ist,
insbesondere durch die vom Rohrabschnitt umgebene Ausnehmung zum Innenraum des Gehäuses. Von Vorteil ist dabei, dass die Versorgungsleitung zum Innenraum abgedichtet durchführbar ist.

Bei einer vorteilhaften Ausgestaltung weist das Gehäuse Ausnehmungen auf, durch welche der vom Lüfter geförderte Luftstrom austritt,
insbesondere wobei die Ausnehmungen an einer am Gehäuse ausgebildeten Stufe angeordnet sind, so dass der austretende Luftstrom entlang von am Gehäuse ausgebildeten Kühlrippen strömt, insbesondere wobei die Kühlrippen zumindest abschnittsweise parallel sich erstrecken. Von Vorteil ist dabei, dass eine verbesserte Kühlung des Gehäuses erreichbar ist.

Bei einer vorteilhaften Ausgestaltung ist am Trägerteil ein Auflageabschnitt ausgebildet, auf dem die Leiterplatte aufliegt
und/oder dass an der Dichtungskappe ein Niederhalterabschnitt ausgeformt ist, welcher die Leiterplatte gegen das Trägerteil, insbesondere gegen einen Auflageabschnitt des Trägerteils drückt. Von Vorteil ist dabei, dass die Leiterplatte fixiert ist, wobei der Niederhalterabschnitt an der Innenseite der Dichtungskappe angeordnet ist.

Bei einer vorteilhaften Ausgestaltung ist das Trägerteil am Randbereich der Vertiefung des Gehäuses dicht, insbesondere luftdicht oder dicht gegen einen Überdruck, mit dem Gehäuse verbunden. Von Vorteil ist dabei, dass der vom Lüfter erzeugte Überdruck im vom Lüfter gesehen ausgangsseitigen Raumbereich einen Luftstrom nur durch die Ausnehmungen im Gehäuse antreibt, so dass der austretende Luftstrom entlang der Kühlrippen des Gehäuses führbar ist und somit die Kühlung verbessert ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein erfindungsgemäßes Gehäuse 1 eines Elektrogeräts, insbesondere Umrichters, mit Dichtungselement 7 in Schrägansicht gezeigt, wobei der Deckel des Geräts entfernt ist..

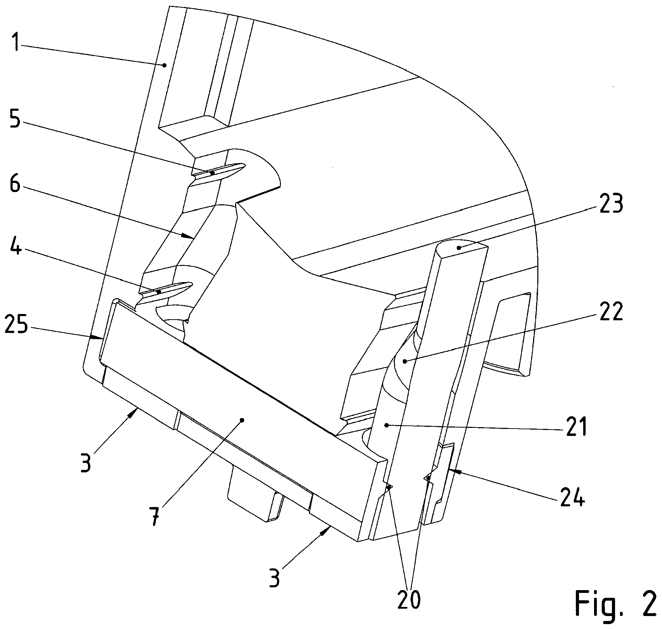

In der Figur 2 ist der Kabeleinführbereich des Geräts angeschnitten und in Schrägansicht gezeigt, wobei ein Kabel 8 in einer der geschwungen verlaufenden, in die Wandung des Gehäuses 1 eingebrachten, durchgehenden Nuten 6 vorgesehen ist.

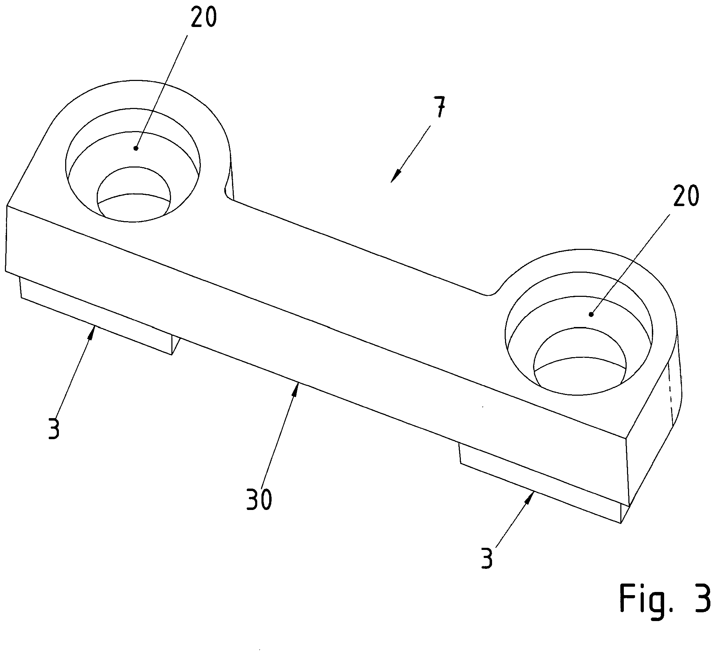

In der Figur 3 ist das Dichtungselement 7 in Schrägansicht gezeigt.
In der Figur 4 ist ein Lüftermodul in Schrägansicht gezeigt, das einen auf einem Trägerteil 45 aufgeklipst angeordnete Lüfter 40 und eine Dichtungskappe 42 mit Ringkragenabschnitt 41 gezeigt.

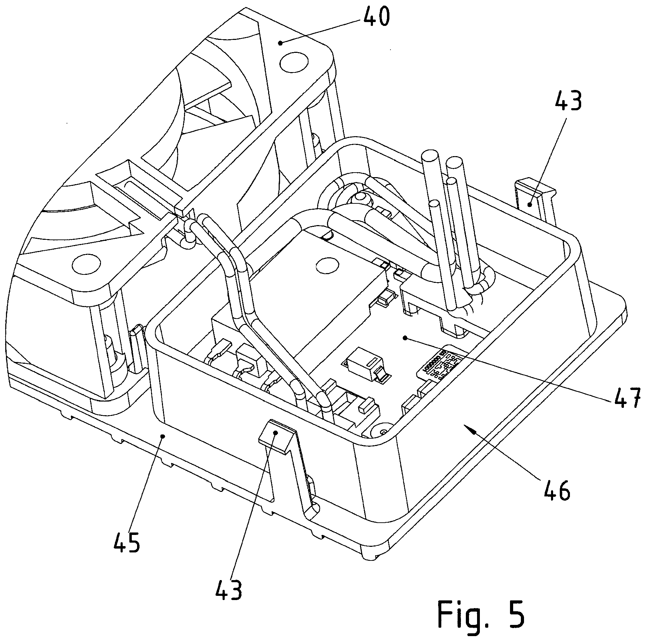

In der Figur 5 ist ein vergrößerter Ausschnitt zur Figur 4 gezeigt, wobei die Dichtungskappe 42 entfernt ist, so dass die Leiterplatte 47 mit ihrer Bestückung sichtbar ist.
In der Figur 6 ist das Lüftermodul etwas entfernt vom Gehäuse 1 dargestellt.
In der Figur 7 ist eine Schrägansicht des Gehäuses 1 mit aufgesetztem Deckel 60 gezeigt, wobei Ausnehmungen 70 zur Ausleitung von Luft sichtbar sind.

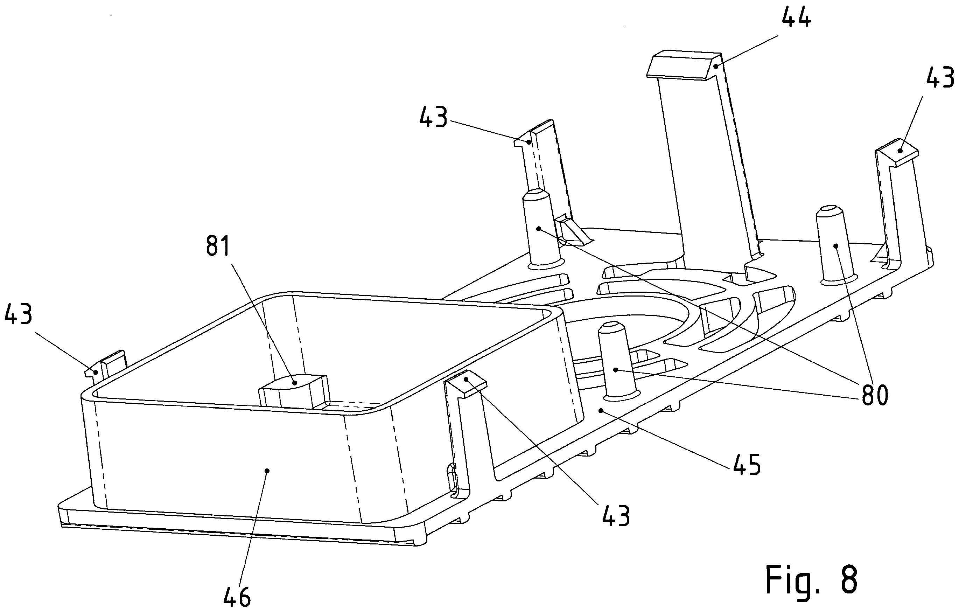

In der Figur 8 ist das Trägerteil 45 in Schrägansicht aus einer Blickrichtung gezeigt.

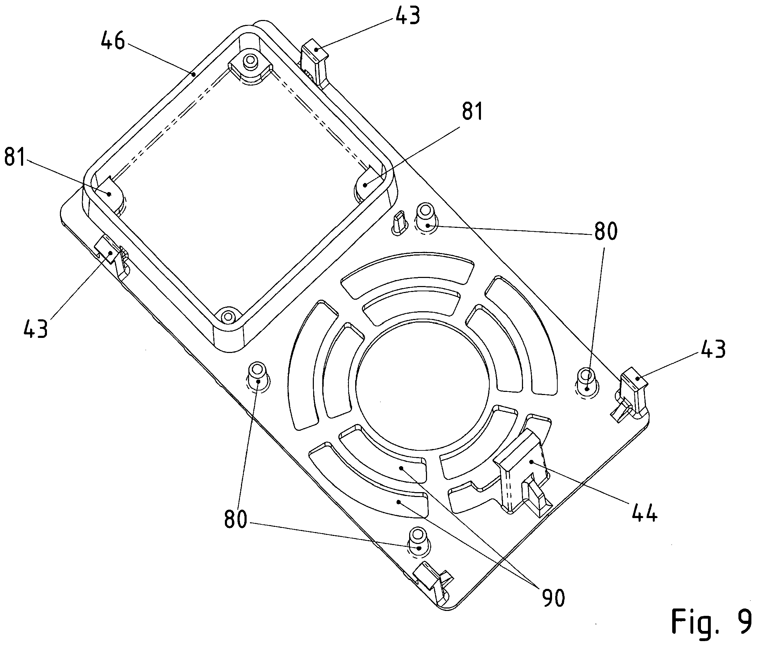

In der Figur 9 ist das Trägerteil 45 in Schrägansicht aus einer anderen Blickrichtung gezeigt.
In der Figur 10 eine Schrägansicht des Gehäuses 1 aus einer anderen Blickrichtung gezeigt.

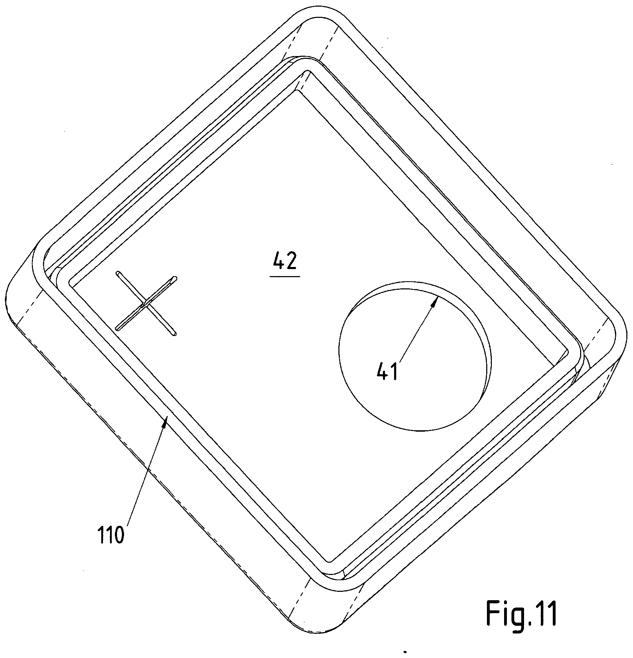

In der Figur 11 ist die Dichtungskappe 42 mit ihrem Niederhalterabschnitt 110 zum Niederhalten der Leiterplatte 47 gezeigt.

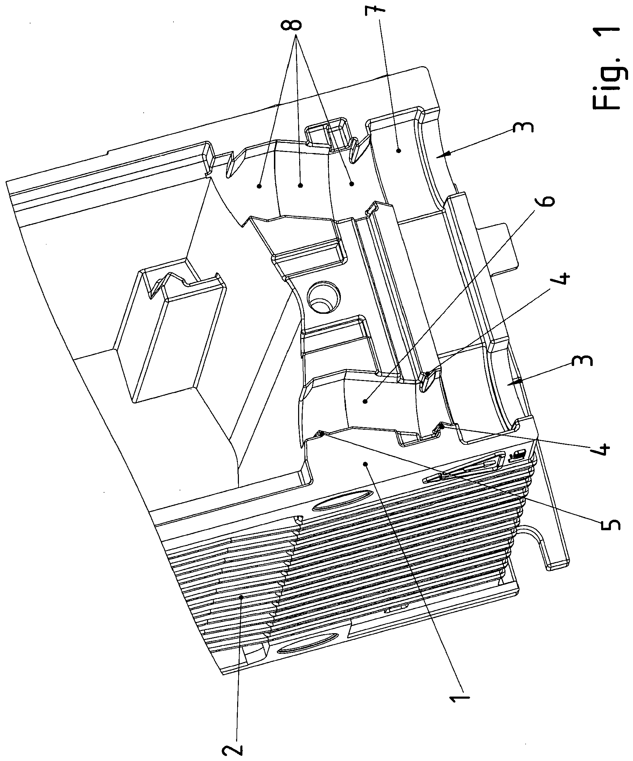

Wie in Figur 1 gezeigt, ist der Deckel des Geräts auf das Gehäuse 1, insbesondere Aluminiumgehäuse, des Elektrogeräts aufsetzbar, wobei der Deckel als Kunststoffspritzgussteil ausführbar ist und im Berührbereich zwischen Gehäuse 1 und Deckel eine umlaufende Flachdichtung am Deckel vorgesehen ist. Beim Aufsetzen des Deckels auf das Gehäuse 1 wird der Deckel somit mit seiner Flachdichtung an das Gehäuse angedrückt und dichtet somit ab.

Dabei drückt die Dichtung auch auf ein in einer Vertiefung des Gehäuses 1 eingesetztes Dichtungselement 7.

Das Dichtungselement 7 weist zwei Kabeldurchführungen auf. Jede der Kabeldurchführungen ist in einem Schenkelabschnitt 3 angeordnet, wobei die schenkelabschnitte 3 mittels eines Jochabschnitts verbunden sind. Jeder Schenkelabschnitt 30 weist eine durchgehende Ausnehmung auf, durch die ein Kabel 8 durchführbar ist. Eine an der Ausnehmung umlaufende Dichtlippe 20 drückt dabei auf das Kabel 8 und dichtet somit das Kabel gegen das Dichtungselement 7 ab.

Am Boden der Vertiefung im Gehäuse 1 ist eine quer zur Kabelrichtung verlaufende Nut 24 angeordnet, in welche der Schenkelabschnitt 3 des Dichtungselements 7 einsteckbar ist. Das Gehäuse 1 weist auch eine quer zur Nut 24 verlaufende und quer zur Kabelrichtung verlaufende Seitennut 25 auf, die ebenfalls in der Wandung des Gehäuses 1 eingebracht oder an ihr ausgeformt ist. Der seitliche Endabschnitt des Dichtungselements 7 erstrecket sich in diese Seitennut 25. Somit ist das Dichtungselement 7 mittels der Nuten (24, 25) fixiert und kann nicht in Kabelrichtung herausrutschen aus der Vertiefung des Gehäuses, insbesondere der Gehäusewand.

Das Kabel weist eine Leitung, insbesondere einen Innenleiter, auf, der vorzugsweise aus Kupfer gefertigt ist und nachfolgend auch als Seele 23 bezeichnet wird. Diese Leitung ist von Isoliermaterial 22, also elektrisch isolierendem Material, umgeben, die wiederum von einer metallischen Schirmung 21 umgeben ist. Die Schirmung 21 ist vorzugsweise als Metallgeflecht ausgeführt. An seiner äußeren Oberfläche weist das Kabel 8 einen Mantel auf, der aus elektrisch isolierendem Material ausgeführt ist.

Das Gehäuse weist Kühlrippen 2 auf zur verbesserten Wärmeabfuhr von Leistungsbauelementen, die mit dem Gehäuse wärmeleitend verbunden sind.

Der Deckel ist aus Kunststoff ausgeführt. An seiner Innenseite ist eine Leiterplatte mit Signalelektronik angeordnet, welche als Ansteuerung der Leistungsbauelemente fungiert.

Das durch die Ausnehmung im Dichtungselement 7 durchgeführte Kabel 8 ist in eine im Wesentlichen in Kabelrichtung verlaufende, geschwungen ausgeführte, insbesondere S-förmig oder mäanderförmig verlaufende Nut eingelegt. Die Nut ist dabei in der Gehäusewandung angeordnet. Mittels des geschwungenen Verlaufs ist einerseits eine Zugentlastung bewirkbar, da eine erhöhte Reibung erzeugt ist. Andererseits sind an der Nutwand scharfkantige Krallenabschnitte (4, 5) ausgebildet. Diese Krallenabschnitte 4 schneiden sich in die Schirmung 21 des Kabels 8 ein. Das Kabel ist vorzugsweise entmantelt im Bereich der Nut. Im Bereich der Ausnehmung des Dichtungselements jedoch weist das Kabel 8 vorzugsweise seinen Mantel auf, so dass die Dichtlippe 20 dicht am Mantel des Kabels 8 anliegt.

Vor Einlegen des Kabels 8 in die Nut ist der Durchmesser des entmantelten Kabels im Bereich der Krallenabschnitte (4, 5) etwas größer als der lichte Innendurchmesser der Nut. Somit schneidet sich schon beim Einlegen des Kabels der jeweilige Krallenabschnitt (4, 5) in die Schirmung 21 ein. Auf diese Weise ist eine einfache elektrische Verbindung des Gehäuses mit der Schirmung 21 erreicht. Vorzugswiese wird das Gehäuse 1 und/oder die Schirmung 21 auf diese Weise mit elektrisch Masse verbunden, also geerdet..

Das Dichtungselement 7 ist vorzugsweise aus Gummi oder einem Kunststoff gefertigt, der elastischer, also einfacher verformbar, als das Material des Mantels des Kabels 8 ist. Das Dichtungselement 7 ist samt seiner Schenkelabschnitte, Dichtlippen und Jochabschnitt einstückig, insbesondere einteilig, ausgeführt. Auch eine Ausführung als Kunststoffspritzgussteil ist ermöglicht.

Insbesondere sind weitere Kabeldurchführungen vorgesehen. Hierzu verbindet dann der Jochabschnitt die entsprechend höhere Anzahl von Schenkelabschnitten. Somit sind durch die Ausnehmungen der Schenkelabschnitte entsprechend viele Kabel durchgeführt und mittels jeweiliger umlaufender Dichtlippe abgedichtet..

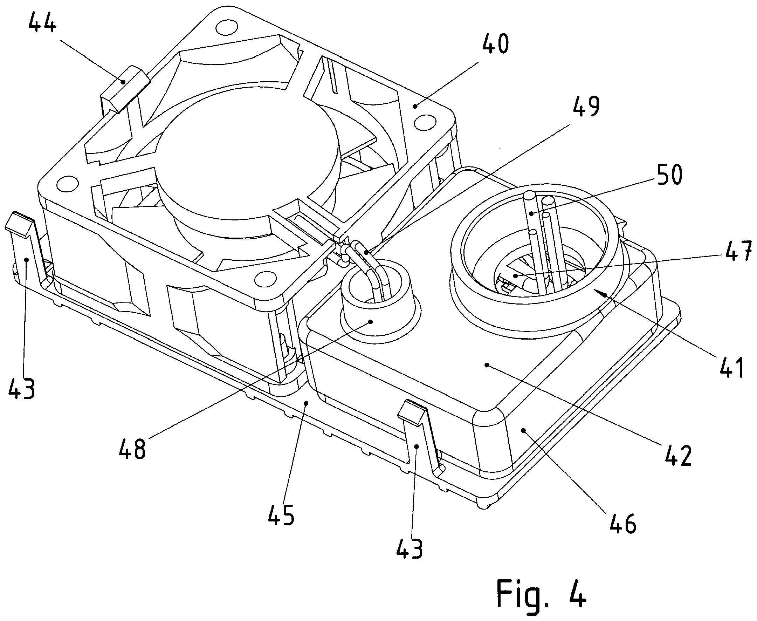

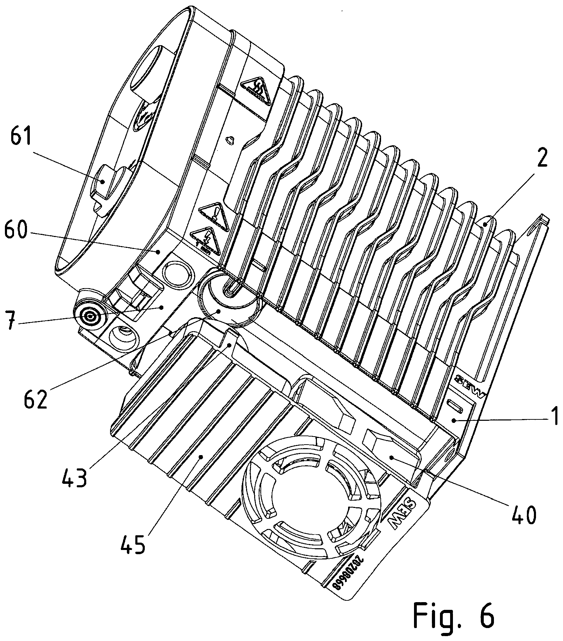

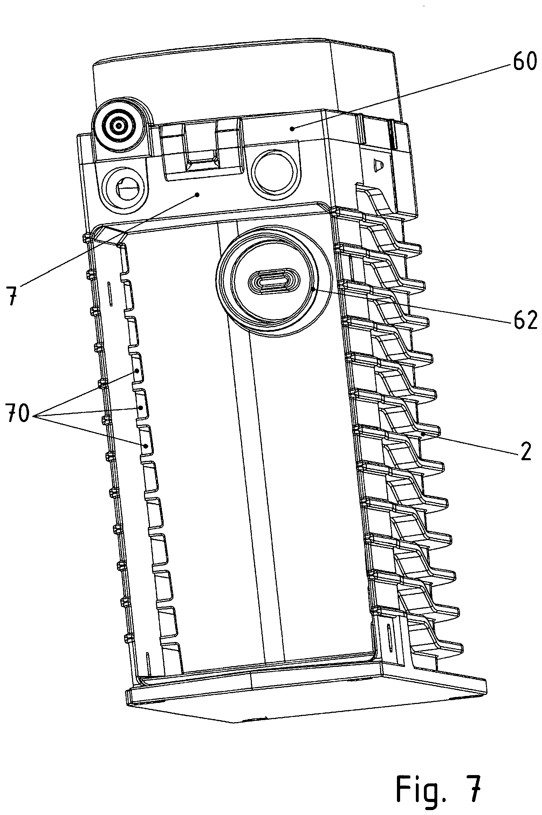

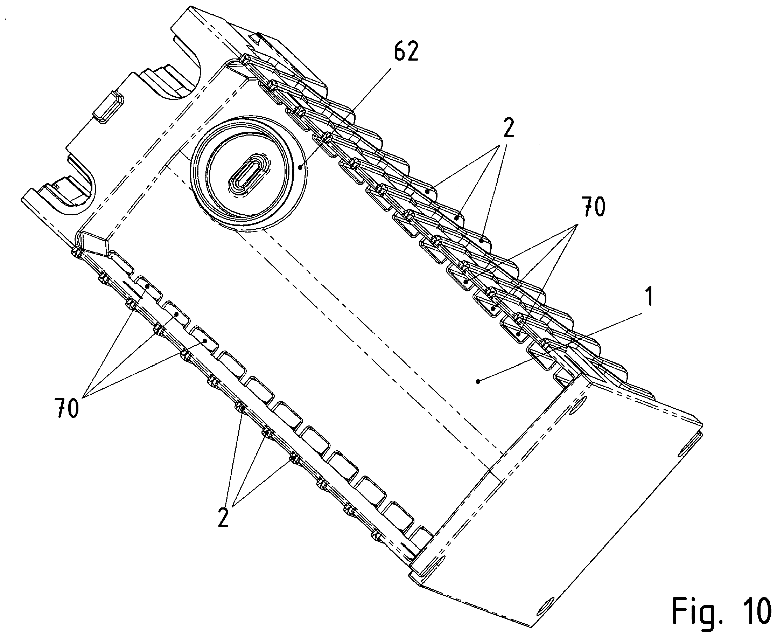

Wie in der Figur 4 gezeigt, ist das Lüftermodul aus einem Trägerteil gebildet, welches als einstückige , also einteilig hergestelltes, Kunststoffspritzgussteil gefertigt ist. Dabei weist dieses Trägerteil 45 eine Rastnase auf, mit der der Lüfter 40 aufklipsbar ist auf dem Trägerteil 45. Außerdem weist das Trägerteil 45 Rastnasen auf, die in einen jeweiligen Vorsprung oder Kragenabschnitt des Gehäuses 1 einrasten, so dass das Trägerteil in der Figur 6, 7, und 10 sichtbaren Vertiefung des Gehäuses 1 aufnehmbar und somit rastverbindbar ist.

Außerdem weist das Trägerteil 45 einen umlaufenden Wandabschnitt 46 auf, der eine in dem im Inneren des umlaufenden Wandabschnitts 46 umgebenen Raumbereich aufgenommene, mit elektronischen Bauelementen bestückte Leiterplatte 47 zumindest teilweise gehäusebildend umgibt. Dabei liegt die Leiterplatte auf einem Auflageabschnitt 81 auf und ist vorzugsweise mit am Trägerteil 45 ausgebildeten Zentrierstiften ausgerichtet.

Eine auf den umlaufenden Wandabschnitt 46 übergestülpt aufgesetzte Dichtungskappe 42 weist an ihrer Innenseite einen umlaufenden Niederhalterabschnitt 110 auf. Beim Aufsetzen der Dichtungskappe 42 wird somit von diesem Niederhalterabschnitt 110 die Leiterplatte 47 gegen das Trägerteil 45 gedrückt und somit die Leiterplatte fixiert.

Die Dichtungskappe 42 ist ebenfalls einstückig, also einteilig, mit ihrem Niederhalterabschnitt 110 und einem ersten Ringkragenabschnitt 41 sowie einem weiteren Ringkragenabschnitt 48 ausgeführt, wobei der lichte Innendurchmesser des weiteren Ringkragenabschnitts 48 kleiner ist als der lichte Innendurchmesser des ersten Ringkragenabschnitts 41.

Von der Leiterplatte 47 ist eine Versorgungsleitung 49 durch den weiteren Ringkragenabschnitt 48 zum Lüfter 40 geführt. Außerdem ist eine Versorgungsleitung 50 vom Innenraum des Gehäuses 1 zur Leiterplatte 47 durch den ersten Ringkragenabschnitt 41 geführt.

Beim Einsetzen des Lüftermoduls in die das Lüftermodul aufnehmende Vertiefung des Gehäuses 1 wird der erste Ringkragenabschnitt 41 auf einen Rohrabschnitt 62 des Gehäuses übergestülpt. Dabei wird eine dichte Verbindung hergestellt, weil der Ringkragenabschnitt 41 am Rohabschnitt 62 anliegt.

Das Trägerteil 45 weist eine Rastnase 43 zur Verbindung mit dem Gehäuse 1 auf, insbesondere mit einem Vorsprung am Gehäuse 1.

Das Trägerteil 45 weist eine Rastnase 44 zur Verbindung des Lüfters 40 mit dem Trägerteil 45 auf.

Mit dem an der Außenseite des Deckels 60 angeordneten Eingabemittel 61 sind Parameter der am Deckel 60 angeordneten Signalelektronik vorgesehen.

Das Lüftermodul weist einen Lüfter 40 auf, der Luft ansaugt, welche durch Ausnehmungen 90 im Trägerteil 45 einströmt. Die Ausnehmungen 90 bilden dabei ein Lüfterhaubengitter.

Der vom Lüfter 40 geförderte Luftstrom wird durch Ausnehmungen 70 des Gehäuses nach außen gefördert, wobei der Luftstrom entlang der am Gehäuse 1 ausgeformten Kühlrippen 2 geleitet wird. Hierzu sind die Ausnehmungen 70 entsprechend als Luftumleitung in die Zwischenraumbereiche zwischen den Kühlrippen geformt beziehungsweise in einer Stufe des Gehäuses vorgesehen, so dass sie den Luftstrom direkt jeweils in einen Zwischenraum zwischen zwei der parallel zueinander sich erstreckenden Kühlrippen 2 oder zumindest Kühlrippenabschnitte weisen.

Mittels der am Trägerteil 45 ausgeformten Zentrierstiftabschnitte 80 ist der Lüfter 40 positioniert.

Das Trägerteil 45 weist eine rechteckförmige Grundplatte auf, an der der umlaufende und somit den Aufnahmebereich für die bestückte Leiterplatte seitlich gehäusebildend umgebende Wandabschnitt 46 ausgeformt ist und die Zentrierstiftabschnitte 80 sowie die Rastnasen (43, 44)

### Bezugszeichenliste

1 Gehäuse, insbesondere Aluminiumgehäuse
2 Kühlrippen
3 Schenkelabschnitt
4 Krallenabschnitt
5 krallenabschnitt
6 Nut, insbesondere geschwungen verlaufende Nut
7 Dichtungselement
8 Kabel
20 Dichtlippe, umlaufend
21 Schirmung
22 Isoliermaterial
23 Seele, insbesondere Kupferseele
24 Nut
25 Seitennut
30 Jochabschnitt
40 Lüfter
41 Ringkragenabschnitt
42 Dichtungskappe
43 Rastnase zur Verbindung mit dem Gehäuseteil 1
44 Rastnase zur Verbindung des Lüfters 40 mit dem Trägerteil 45
45 Trägerteil
46 Wandabschnitt
47 Leiterplatte
48 Ringkragenabschnitt
49 Versorgungsleitung des Lüfters 40
50 Versorgungsleitung der auf der Leiterplatte 47 vorgesehenen Elektronik
60 Deckel
61 Eingabemittel
62 Rohrabschnitt
70 Ausnehmungen
80 Zentrierstiftabschnitte
81 Auflageabschnitt
90 Ausnehmungen
110 Niederhalterabschnitt

## Patentansprüche

1. Elektrogerät mit Gehäuse (1) und auf dem Gehäuse aufsetzbarem Deckel, wobei in einer Vertiefung des Gehäuses, insbesondere der Wandung des Gehäuses, ein Dichtungselement (7) angeordnet ist, das zwischen dem Gehäuse (1) und dem Deckel angeordnet ist, wobei das Dichtungselement (7) eine Ausnehmung (3) zur Durchführung eines Kabels (8) aufweist, wobei das Kabel (8) in einer geschwungen verlaufenden Nut (24) des Gehäuses, insbesondere der Wandung des Gehäuses, eingelegt ist, **dadurch gekennzeichnet, dass** das Gehäuse einen Krallenabschnitt (4, 5) aufweist, der in die Schirmung des Kabels (8) eingekrallt und/oder eingeschnitten ist.

2. Elektrogerät nach Anspruch 1, **dadurch gekennzeichnet, dass** das Gehäuse (1) samt Krallenabschnitt (4, 5) aus Metall, insbesondere Aluminium, ausgebildet ist.

3. Elektrogerät nach mindestens einem der vorangegangenen Ansprüche,
**dadurch gekennzeichnet, dass**
zwischen Deckel und Gehäuse eine Dichtung, insbesondere Flachdichtung angeordnet ist, insbesondere die am Deckel angespritzt ist,
insbesondere wobei beim Aufsetzen des Deckels die Dichtung abschnittsweise gegen das Gehäuse und in einem anderen Abschnitt gegen das Dichtungselement (7) gepresst ist, insbesondere so dass das Dichtungselement (7) in die Vertiefung gedrückt ist.

4. Elektrogerät nach mindestens einem der vorangegangenen Ansprüche,
**dadurch gekennzeichnet, dass**
das Dichtungselement (7), insbesondere ein Schenkelabschnitt (3) des Dichtungselements, eine Ausnehmung aufweist, durch welche das Kabel (8) hindurchgeführt ist, wobei eine Dichtlippe (20), insbesondere umlaufende Dichtlippe, des Dichtungselements (7) am Kabel (8) anliegt.

5. Elektrogerät nach mindestens einem der vorangegangenen Ansprüche,
**dadurch gekennzeichnet, dass**
die geschwungen verlaufende Nut (24, 25) S-förmig verläuft.

6. Elektrogerät nach mindestens einem der vorangegangenen Ansprüche,
**dadurch gekennzeichnet, dass**
im Gehäuse quer zur Kabelrichtung eine Nut (24) ausgeformt ist, insbesondere wobei quer zur Nutrichtung und quer zur Kabelrichtung eine Seitennut (25) im Gehäuse ausgeformt ist,
wobei das Dichtungselement (7) in die Nut (24) und/oder Seitennut (25) hineinragt und somit in Kabelrichtung und entgegen der Kabelrichtung begrenzt ist und/oder im Gehäuse gehalten ist.

7. Elektrogerät nach mindestens einem der vorangegangenen Ansprüche,
**dadurch gekennzeichnet, dass**
das Dichtungselement (7) insbesondere ein weiterer Schenkelabschnitt (3) des Dichtungselement (7) eine weitere Ausnehmung aufweist, durch welche ein weiteres Kabel hindurchgeführt ist,
wobei eine Dichtlippe (20) insbesondere umlaufende Dichtlippe, des Dichtungselements (7) am weiteren Kabel (8) anliegt,
insbesondere wobei das Dichtungselement (7) einen Jochabschnitt aufweist, der die Schenkelabschnitte miteinander verbindet.

8. Elektrogerät nach mindestens einem der vorangegangenen Ansprüche,
**dadurch gekennzeichnet, dass**
das Kabel (8) eine Leitung aufweist, die von einem Isoliermaterial (22) umgeben ist, welches von einer Schirmung (21) umgeben ist,
insbesondere wobei im Bereich der Dichtlippe (20) des Dichtungselements (7) ein Mantel aus elektrisch isolierendem Material die Schirmung (21) umgibt,
insbesondere wobei das Kabel (8) im Beriech der Krallenabschnitte (4, 5) entmantelt ist.

9. Elektrogerät nach mindestens einem der vorangegangenen Ansprüche,
**dadurch gekennzeichnet, dass**
der lichte Innendurchmesser der Nut im Bereich des Krallenabschnitts (4, 5) kleiner ist als der Außendurchmesser des entmantelten Kabels (8).

10. Elektrogerät nach mindestens einem der vorangegangenen Ansprüche,
**dadurch gekennzeichnet, dass**
im Deckel Signalelektronik aufgenommen ist, mit welcher Leistungshalbleiterschalter ansteuerbar sind, die wärmeleitende mit dem Gehäuse verbunden sind.

## Claims

1. An electrical device with a housing (1) and a cover which can be placed on the housing,
wherein
a sealing element (7) which is arranged between the housing (1) and the cover is arranged in an indentation of the housing, in particular of the wall of the housing,
wherein the sealing element (7) has a cutout (3) for a cable (8) to pass through,
wherein the cable (8) is laid in a curved groove (24) of the housing, in particular of the wall of the housing,
**characterised in that** the housing has a claw portion (4, 5) which hooks and/or cuts into the shielding of the cable (8).

2. An electrical device according to Claim 1,
**characterised in that**
the housing (1) plus claw portion (4, 5) is formed from metal, in particular aluminium.

3. An electrical device according to at least one of the preceding claims,
**characterised in that**
between the cover and housing there is arranged a seal, in particular flat seal, in particular which is moulded onto the cover,
in particular with the seal, upon placing the cover on, being pressed in portions against the housing and in another portion being pressed against the sealing element (7), in particular so that the sealing element (7) is pressed into the indentation.

4. An electrical device according to at least one of the preceding claims,
**characterised in that**
the sealing element (7), in particular a leg portion (3) of the sealing element, has a cutout through which the cable (8) is passed,
with a sealing lip (20), in particular circumambient sealing lip, of the sealing element (7) lying against the cable (8).

5. An electrical device according to at least one of the preceding claims,
**characterised in that**
the curved groove (24, 25) runs in an S-shape.

6. An electrical device according to at least one of the preceding claims,
**characterised in that**
a groove (24) is formed in the housing transversely to the cable direction,
in particular with a lateral groove (25) being formed in the housing transversely to the groove direction and transversely to the cable direction,
with the sealing element (7) projecting into the groove (24) and/or lateral groove (25) and thus being limited in the cable direction and counter to the cable direction and/or being held in the housing.

7. An electrical device according to at least one of the preceding claims,
**characterised in that**
the sealing element (7), in particular a further leg portion (3) of the sealing element (7), has a further cutout through which a further cable is passed,
with a sealing lip (20), in particular circumambient sealing lip, of the sealing element (7) lying against the further cable (8),
in particular with the sealing element (7) having a yoke portion which connects the leg portions together.

8. An electrical device according to at least one of the preceding claims,
**characterised in that**
the cable (8) has a line which is surrounded by an insulating material (22), which is surrounded by shielding (21),
in particular with a sheath made of electrically insulating material surrounding the shielding (21) in the region of the sealing lip (20) of the sealing element (7),
in particular with the cable (8) being stripped of its sheath in the region of the claw portions (4, 5).

9. An electrical device according to at least one of the preceding claims,
**characterised in that**
the internal diameter of the groove in the region of the claw portion (4, 5) is smaller than the external diameter of the stripped cable (8).

10. An electrical device according to at least one of the preceding claims,
**characterised in that**
signal electronics are accommodated in the cover, with which electronics power semiconductor switches can be controlled which are connected to the housing in thermally conductive manner.

## Revendications

1. Appareil électrique avec un boîtier (1) et un couvercle pouvant être posé sur le boîtier,
sachant qu'un élément d'étanchéité (7) est disposé dans un renfoncement du boîtier, en particulier de la paroi du boîtier, élément qui est disposé entre le boîtier (1) et le couvercle,
sachant que l'élément d'étanchéité (7) présente un évidement (3) destiné au passage d'un câble (8),
sachant que le câble (8) est inséré dans une rainure (24) du boîtier, en particulier de la paroi du boîtier, rainure qui s'étend de manière incurvée,
**caractérisé en ce que** le boîtier présente une partie formant griffe (4, 5), qui est accrochée et/ou incisée dans le blindage du câble (8).

2. Appareil électrique selon la revendication 1, **caractérisé en ce que** le boîtier (1), y compris la partie formant griffe (4, 5), est réalisé en métal, en particulier en aluminium.

3. Appareil électrique selon au moins une des revendications précédentes, **caractérisé en ce qu'**un joint d'étanchéité, en particulier un joint d'étanchéité plat, est disposé entre le couvercle et le boîtier, joint qui est en particulier moulé par injection sur le couvercle,
sachant en particulier que lors de la mise en place du couvercle, le joint d'étanchéité est pressé pour partie contre le boîtier, et est pressé dans une autre partie contre l'élément d'étanchéité (7), en particulier de telle sorte que l'élément d'étanchéité (7) est enfoncé dans le renfoncement.

4. Appareil électrique selon au moins une des revendications précédentes, **caractérisé en ce que** l'élément d'étanchéité (7), en particulier une partie formant branche (3) de l'élément d'étanchéité, présente un évidement à travers lequel on fait passer le câble (8),
sachant qu'une lèvre d'étanchéité (20), en particulier une lèvre d'étanchéité périphérique, de l'élément d'étanchéité (7) s'applique contre le câble (8).

5. Appareil électrique selon au moins une des revendications précédentes, **caractérisé en ce que** la rainure (24) s'étendant de manière incurvée s'étend en forme de S.

6. Appareil électrique selon au moins une des revendications précédentes, **caractérisé en ce qu'**une rainure (24) est façonnée dans le boîtier transversalement à la direction du câble,
sachant en particulier qu'une rainure latérale (25) est façonnée dans le boîtier transversalement à la direction de la rainure et transversalement à la direction du câble, sachant que l'élément d'étanchéité (7) pénètre dans la rainure (24) et/ou dans la rainure latérale (25) et est ainsi limité dans le sens du câble et dans le sens contraire et/ou est maintenu dans le boîtier.

7. Appareil électrique selon au moins une des revendications précédentes, **caractérisé en ce que** l'élément d'étanchéité (7), en particulier une autre partie formant branche (3) de l'élément d'étanchéité (7), présente un évidement à travers lequel on fait passer un autre câble,
sachant qu'une lèvre d'étanchéité (20), en particulier une lèvre d'étanchéité périphérique, de l'élément d'étanchéité (7) s'applique contre l'autre câble (8),
sachant en particulier que l'élément d'étanchéité (7) présente une partie formant arche, qui relie entre elles les parties formant branches.

8. Appareil électrique selon au moins une des revendications précédentes, **caractérisé en ce que** le câble (8) présente une ligne électrique qui est entourée par un matériau isolant (22), lequel est entouré par un blindage (21),
sachant en particulier qu'une gaine en matériau électriquement isolant entoure le blindage (21) dans la région de la lèvre d'étanchéité (20) de l'élément d'étanchéité (7), sachant en particulier que le câble (8) est dégainé dans la région des parties formant griffes (4, 5).

9. Appareil électrique selon au moins une des revendications précédentes, **caractérisé en ce que** le diamètre intérieur de passage de la rainure dans la région de la partie formant griffe (4, 5) est inférieur au diamètre extérieur du câble (8) dégainé.

10. Appareil électrique selon au moins une des revendications précédentes, **caractérisé en ce qu'**un système électronique de signalisation est reçu dans le couvercle, système qui permet de commander des commutateurs à semi-conducteurs de puissance qui sont reliés en conduction de chaleur au boîtier.
